# EUROPEAN PATENT APPLICATION

(11) **EP 0 622 845 A2**
(43) Date of publication of application: **02.11.1994**
(21) Application number: 93120553.8
(22) Date of filing: 20.12.1993
(51) Int. Cl.: H01L 23/31, H01L 21/60

(54) **Apparatus and method for tape automated bonding beam lead insulation**

(30) Priority: 30.04.1993 US 55622
(71) Applicant: Hewlett-Packard Company, Palo Alto, California 94304 (US)
(72) Inventor: Reid, William Bruce, Solano Beach, CA 92075 (US); Tappon, Ellen Rieck, Corvallis, OR 97330 (US); Garcia, Andre, Poway, CA 92064 (US); Salter, James, Sacramento, CA 95816 (US)
(74) Representative: Liesegang, Roland, Dr.-Ing.

(57) **Abstract**

An improved apparatus for tape automated bonding insulation including: a substrate (12); at least one electrical contact (18) on the substrate (12); an electrical lead (14) coupled to the electrical contact (18); and an insulator material (20) attached to the substrate (12) for insulating the electrical lead (14) from the substrate (12). In a specific embodiment the electrical contact (18) is a substantially flat and thin electrically conductive layer (18). In another specific embodiment the insulator material (20) is a polymer photomask material (20) laminated to the substrate (12) and etched to form a raised insulator (20). The improved apparatus for tape automated bonding insulation reduces cost and improves insulation reliatility.

## Description

This invention relates to tape automated bonding and more particularly to insulation of tape automated bonding (TAB) circuits from integrated circuits.

While the present invention is described herein with reference to illustrative embodiments for particular applications, it should be understood that the invention is not limited thereto. Those having ordinary skill in the art and access to the teachings provided herein will recognize additional modifications, applications, and embodiments within the scope thereof and additional fields in which the present invention would be of significant utility.

### Description of the Related Art:

Tape automated bonding (TAB) circuits are used for many applications including integrated circuit packaging and interconnection to integrated thermal inkjet printheads. TAB circuits are fabricated by plating copper or gold conductors and circuit traces onto a flexible polyimid substrate. In a typical application, the TAB circuits include beam leads that are welded to contact pads on an integrated circuit substrate to provide interconnection between the integrated circuit and the leads of a package. The TAB beam leads are copper leads that can be plated with gold and are generally rectangular in cross section.

A TAB lead must be insulated from an integrated circuit substrate, because the substrate itself is conductive and is used as a part of the circuit. During processing of a silicon wafer to fabricate integrated circuits, a glassy insulation layer is applied over the wafer; however, this layer cracks when the wafer is sawn into individual integrated circuit substrates, so is ineffective as an insulator.

A conventional approach for providing insulation for a TAB beam lead is to plate a 0.001 inch gold bump onto the TAB beam lead to improve bonding reliability and to prevent electrical shorting. The bump on the TAB beam lead is attached to a flat contact pad on the integrated circuit substrate and the TAB beam lead is elevated by the bump, which prevents electrical shorting to the integrated circuit substrate.

Unfortunately, the cost of using gold for this purpose is prohibitive for some consumer products. Inkjet printers such as those sold by Hewlett Pac- kard Company typically include an inkjet pen having an array of nozzles. The inkjet pens are mounted in a carriage which is moved across a page in successive swaths. Each inkjet pen has heater circuits which, when activated, cause ink to be ejected from associated nozzles. The heater circuits are integrated onto an integrated heater circuit substrate and TAB beam leads are used for interconnection to the integrated heater circuit substrate. When the inkjet pens are empty of ink, they are discarded, which requires that the cost of the inkjet pens be as low as possible.

Other conventional approaches to prevent electrical shorting of TAB beam leads to integrated circuits include: pre-forming or post-forming the TAB beam leads to minimize edge shorting. Pre-forming the beam leads involves bending the leads before bonding, which is feasible and commonly used for large soldered leads; however, for very small TAB beam leads pre-forming is a difficult process which has negative effects on TAB bonding performance.

Post-forming the beam leads involves bending the leads after bonding; however, for very small TAB beam leads post-forming is not feasible and bonds may fail in the post-forming process.

Another conventional approach to prevent electrical shorting of TAB beam leads to integrated circuits is to apply encapsulating or insulating material beneath the leads after bonding the leads. This approach is costly and not reliable.

Accordingly, there is a need in the art for an improved apparatus and method for tape automated bonding beam lead insulation that reduces cost and improves insulation reliability.

### SUMMARY OF THE INVENTION

The need in the art is addressed by the improved apparatus for tape automated bonding beam lead insulation of the present invention. The invention includes a substrate with at least one electrical contact provided on the substrate. An electrical lead is coupled to the electrical contact. Insulating material is attached to the substrate for insulating the electrical lead from the substrate.

The improved method of the invention for providing tape automated bonding beam lead insulation includes the steps of: 1) laminating an insulator material on a substrate having at least one electrical contact, and 2) etching the insulator material to form an insulator on the substrate.

### BRIEF DESCRIPTION OF THE DRAWINGS

FIG. 1 is an illustrative diagram showing a conventional TAB beam connection with a gold bump on the TAB beam at the TAB bond to raise the TAB beam to prevent shorting.
FIG. 2 is an illustrative elevation view showing an improved TAB beam insulator according to the present invention.
FIG. 3 is an illustrative top view of section 3-3 of FIG. 2 showing an improved TAB beam insulator according to the present invention.

### DESCRIPTION OF THE INVENTION

The advantageous design and operation of the present invention and illustrative embodiments and exemplary applications will now be described with reference to the accompanying drawings.

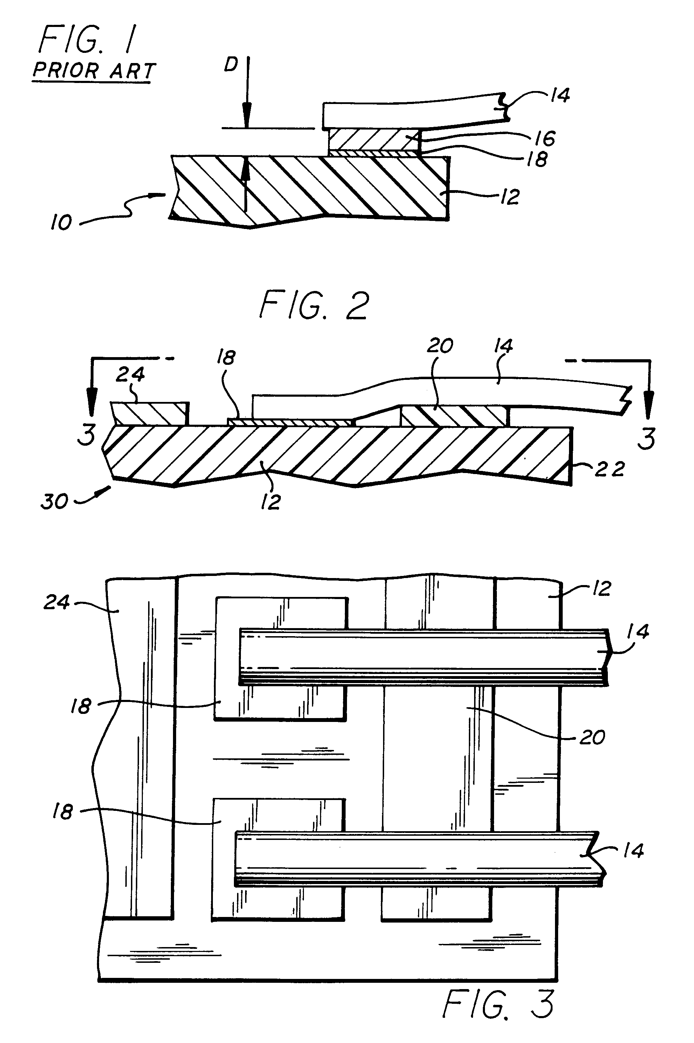

FIG. 1 shows a conventional TAB beam connection 10 between a substrate electrical contact 18 on a substrate 12 and an electrical beam lead 14. A .001 inch high (shown as dimension D on FIG. 1) gold bump 16 is provided between the substrate electrical contact 18 and the electrical beam lead 14. The gold bump 16 elevates the electrical beam lead 14 from the substrate 12, which prevents shorting of the electrical beam lead 14 to the substrate 12.

FIG. 2 is an illustrative elevation view showing an improved TAB beam lead connection 30 according to the present invention and FIG. 3 is an illustrative top view of section 3-3 of FIG. 2. As in the conventional approach an electrical beam lead 14 is bonded or welded to a substrate electrical contact 18 on a substrate 12. An insulator 20 is attached to the substrate 12 between the electrical beam lead 14 and the substrate 12. As discussed below, the insulator 20 can be placed on the substrate wherever an insulator is required.

An inkjet pen has an array of nozzles from which ink is expelled when heater circuits in the inkjet pen are activated. The heater circuits are integrated onto a heater circuit substrate and nozzles are formed on top of the heater circuit substrate. To form the ink firing chamber for each nozzle, barrier material is used. This barrier material is a polymer photomask material, which is laminated to a wafer as part of the wafer processing to fabricate heater circuit substrates. Then the barrier material is photo-defined by a barrier mask to the geometry required for the ink firing chambers. Once a wafer is fully processed, the wafer is sawn into sections to form individual heater circuit substrates.

The insulator 20 for the electrical beam lead 14 can be formed in a similar manner. In the case of a heater circuit substrate, the insulator can be formed without any additional processing steps by modifying the barrier mask to leave a thin strip of the barrier material adjacent to the substrate bond pads near the edge of the substrate, as shown in FIGs. 2 and 3, or to leave barrier material on the substrate wherever it is needed to provide insulation.

During intermediate steps of conventional integrated circuit processing, polymer photomask material is applied to an integrated circuit substrate, but entirely removed at the end of the processing. To form an insulator on the substrate, a processing step of laminating a polymer photomask material to the integrated circuit substrate is added. Alternately, the polymer photomask used to define the etching for the last integrated circuit processing step can also serve as the polymer photomask material for an insulator, rather than removing it and applying another layer of material. Then, the next step is photo-defining the polymer photomask material to form a raised insulator.

FIG. 2 shows the insulator 20, which is formed by laminating a polymer photomask material to the substrate 12 and then photo-defining and etching the polymer photomask material to form a raised insulator attached to the substrate 12. Shorting between the electrical beam lead 14 and the substrate 12 is prevented, because the electrical beam lead is insulated from the substrate 12 by the insulator 20. In FIGs. 2 and 3 the insulator 20 is located between substrate electrical contact 18 and the edge of the substrate 22; however, the location of the insulator 20 can be wherever an insulator is required. For example, the insulator can be configured as islands around each of the substrate electrical contacts 18. FIG. 2 also shows a barrier material 24, which can be used to form ink firing chambers for an inkjet pen.

The improved apparatus and method for tape automated bonding beam lead insulation reduces cost and improves insulation reliability. Thus, the present invention has been described herein with reference to a particular embodiment for a particular application. Nonetheless, those having ordinary skill in the art and access to present teachings will recognize additional modifications, applications, and embodiments within the scope thereof. For example, the polymer photomask material of the present invention may be replaced by other materials without departing from the scope of the present invention.

It is therefore intended by the appended claims to cover any and all such applications, modifications and embodiments within the scope of the present invention.

## Claims

1. An improved apparatus for tape automated bonding beam lead insulation characterized by:
a substrate;
at least one electrical contact (18) on the substrate (12);
an electrical lead (14) coupled to the electrical contact (18); and insulator material (20) attached to the substrate (12) for insulating the electrical lead (14) from said substrate (12).

2. The improved apparatus for tape automated bonding beam lead insulation of Claim 1 wherein the electrical contact (18) is further characterized by a substantially flat and thin electrically conductive layer (18) on the substrate (12).

3. The improved apparatus for tape automated bonding beam lead insulation of Claim 2 wherein the insulator material (20) is further characterized by a polymer photomask material (20) laminated to the substrate (12) and etched to form a raised insulator (20).

4. The improved apparatus for tape automated bonding beam lead insulation of Claim 3 wherein the raised insulator (20) is along an edge (22) of the substrate (12).
